# EUROPEAN PATENT APPLICATION

(11) **EP 2 234 143 A1**
(43) Date of publication of application: **29.09.2010**
(21) Application number: 09700094.7
(22) Date of filing: 04.01.2009
(51) Int. Cl.: H01L 21/205, B05C 11/00, C23C 16/00

(54) **A SYSTEM AND PROCESS FOR PROCESSING THE SUBSTRATE IN THE CHAMBER**

(30) Priority: 01.01.2008 US 968188; 10.05.2008 US 118685
(71) Applicant: Dongguan Anwell Digital Machinery Co., Ltd., Guangdong 523081 (CN)
(72) Inventor: FAN, Chunwah, Dongguan Guangdong 523081 (CN)
(74) Representative: TER MEER - STEINMEISTER & PARTNER GbR
(86) International application number: PCT/CN2009/070004
(87) International publication number: WO 2009/082985

(57) **Abstract**

Mechanisms for processing substrates, such as those for solar panels, are described. According to one aspect of to one embodiment, a processing chamber includes an opening to receive at least one type of chemical, a platform with a plurality of fixtures to hold a plurality of workpieces vertically, a plurality of heaters, each positioned between two of the workpieces, and a plurality of deposition assemblies, each positioned between two of the workpieces. As a result, each of the two of the workpieces positioned between one of the heaters and one of the deposition assemblies, wherein each of the deposition assemblies includes at least two injection panels with holes, the chemical is injected onto the workpieces through the two injection panels.

## Description

### CROSS-REFERENCE TO RELATED APPLICATIONS

This application is a continuation-in-part of co-pending U.S. patent application Ser. No. 11/968,188, entitled "Method and system for handling objects in chambers", filed on Jan. 1, 2008.

### BACKGROUND OF THE INVENTION

1. Field of the Invention

The invention is generally related to the area of manufacturing solar panels. More specially, the present invention is related to designs of chambers for processing substrates or workpieces and the method for doing the same.

2. Description of the Related Art

The sun is believed to provide the cleanest energy. The collections of the solar energy would not contaminate the environment and could be cost-effective if the conversion is done properly. Currently, the solar energy is collected using solar panels. Although, there are a few ways to manufacture the solar panels, the demand for larger solar panels is ever increasing for cost and efficiency reasons. From the manufacturing perspective, the larger the solar panels are, the more difficult it is to keep the solar panels efficient.

There is a demand for better manufacturing processes. The present invention discloses techniques for processing workpieces in a chamber. Although the workpieces are suitable for manufacturing the solar panels, those skilled in the art may appreciate that the techniques herein are equally suitable for other parts or applications.

### SUMMARY OF THE INVENTION

This section is for the purpose of summarizing some aspects of the present invention and to briefly introduce some preferred embodiments. Simplifications or omissions in this section as well as in the abstract or the title of this description may be made to avoid obscuring the purpose of this section, the abstract and the title. Such simplifications or omissions are not intended to limit the scope of the present invention.

In general, the present invention pertains to mechanism for processing substrates, where the substrates or workpieces may be used for manufacturing solar panels. According to one aspect of the present invention, a processing chamber includes an opening to receive at least one type of chemical, a platform with a plurality of fixtures to hold a plurality of workpieces vertically, a plurality of heaters, each positioned between two of the workpieces, and a plurality of deposition assemblies, each positioned between two of the workpieces. As a result, each of the two of the workpieces positioned between one of the heaters and one of the deposition assemblies, wherein each of the deposition assemblies includes at least two injection panels with holes, the chemical is injected onto the workpieces through the two injection panels.

According to another aspect of the present invention, a treatment system includes a load lock chamber, a transfer chamber and one or more process chambers. The load lock chamber is provided to receive workpieces for treatment or process in one or more process chambers. The transfer chamber is provided as a mechanism to move workpieces from one chamber to another chamber. The process chamber includes a set of electrodes used to treat the workpieces with other materials. The process chamber is designed to accommodate a platform that positions each of the workpieces vertically between a pair of planar electrodes. As a result, all workpieces are moved with the platform to be transferred, for example, from one chamber to another chamber. Depending on implementation, the platform may be implemented to include a fixture or a plurality of fixtures, where all of the workpieces may be removably held up by the fixture or each of the workpieces is removably held up by one of the fixtures. A moving mechanism is provided to facilitate the platform or fixture(s) to be moved from one chamber to another chamber.

According to another aspect of the present invention, the moving mechanism includes rollers, wheels running in rails and a transfer device, and studs and a manipulator. With a mechanical maneuver, the fixture(s) can be moved to a designated chamber through the moving mechanism.

The present invention may be implemented as a method, an apparatus, a system or a part of system. According to one embodiment, the present invention is a system for processing workpieces, the system comprises: a chamber including an opening to receive at least one type of chemical; a platform, including a plurality of fixtures to hold a plurality of workpieces vertically; a plurality of heaters, each positioned between two of the workpieces; and a plurality of deposition assemblies, each positioned between two of the workpieces. As a result, each of the two of the workpieces positioned between one of the heaters and one of the deposition assemblies, wherein each of the deposition assemblies includes at least two injection panels with holes, the chemical is injected onto the workpieces through the two injection panels. In one embodiment, the heaters are coupled to an electrical ground, and the deposition assemblies are coupled to a RF source, thus creating an electromagnetic field that excites the chemical for deposition onto the workpieces. The holes on each of the injection panels are progressively enlarged in size from top to bottom.

According to another embodiment, the present invention is a system for handling workpieces in chambers, the system comprises: a transfer stage for receiving the workpieces, wherein fixtures are used to hold the workpieces vertically apart; the transfer stage including a rotary stage mounted with a transferring mechanism; at least a processing chamber. The transferring mechanism in the transfer stage is used to transfer the fixtures so the workpieces to the chamber for processing.

The present invention may be used in a number of applications, such as plasma enhanced chemical vapor deposition (PECVD) that is a process mainly to deposit thin films from a gas state (vapor) to a solid state on a substrate. Other objects, features, and advantages of the present invention will become apparent upon examining the following detailed description of an embodiment thereof, taken in conjunction with the attached drawings.

### BRIEF DESCRIPTION OF THE DRAWINGS

These and other features, aspects, and advantages of the present invention will become better understood with regard to the following description, appended claims, and accompanying drawings where:

FIG. 1 shows an exemplary configuration according to one embodiment of the present invention;

FIG. 2A and FIG. 2B show respectively a front view and a cross sectional view of a process chamber that includes a fixture and can be used in the configuration of FIG. 1;

FIG. 3A and FIG. 3B show respectively a front view and a cross sectional view of a process chamber that includes a plurality of fixtures and can be in the configuration of FIG. 1;

FIG. 4A and FIG. 4B show respectively a front view and a cross sectional view of a process chamber that includes a fixture with wheels running on a set of rails, and can also be used in the configuration of FIG. 1;

FIG. 5 shows an exemplary configuration using a transfer device to move a fixture from one chamber to another;

FIGS. 6A and 6B show respectively a front view and a cross sectional view of a process chamber that includes a fixture placed on a set of studs;

FIG. 7 shows a view of using a manipulator (e.g., a mechanical arm) to raise a fixture to move from one chamber to another; and

FIG. 8A and FIG. 8B together show a front view and cross sectional view of linear array arrangement of rod or tube type electrodes;

FIG. 9A shows one exemplary processing chamber designed to process planar substrates according to one embodiment of the present invention;

FIG. 9B shows an exemplary panel through which active gas can be injected onto substrates being processed in a chamber;

FIG. 9C shows a cross-section side view of the deposition assembly 904;

Another exemplary panel through which active gas can be injected onto substrates being processed in a chamber;

FIG. 9D shows another exemplary processing chamber designed to process planar substrates according to one embodiment of the present invention;

FIG. 10A and FIG. 10B show respectively another two exemplary processing chambers designed to process planar substrate according to one embodiment of the present invention;

FIG. 11A and FIG. 11B show yet another two exemplary processing chamber designed to process planar substrate according to one embodiment of the present invention;

FIG. 12A shows a exemplary panel according to another embodiment of the invention, through which active gas can be injected onto substrates being processed in a chamber;

FIG. 12B shows a cross-section side view of a deposition assembly with the injection panel 1232;

FIG. 12C shows a exemplary panel according to yet another embodiment of the invention, through which active gas can be injected onto substrates being processed in a chamber;

FIG. 12D shows a cross-section side view of a deposition assembly with the injection panel 1252;

FIG. 12E shows a exemplary panel according to still another embodiment of the invention, through which active gas can be injected onto substrates being processed in a chamber; and

FIG. 12F shows a cross-section side view of a deposition assembly with the injection panel 1272.

### DETAILED DESCRIPTION OF ILLUSTRATED EMBODIMENTS

The detailed description of the present invention is presented largely in terms of procedures, steps, logic blocks, processing, or other symbolic representations that directly or indirectly resemble the handling of workpieces in a system. These descriptions and representations are typically used by those skilled in the art to most effectively convey the substance of their work to others skilled in the art.

Reference herein to "one embodiment" or "an embodiment" means that a particular feature, structure, or characteristic described in connection with the embodiment can be included in at least one embodiment of the invention. The appearances of the phrase "in one embodiment" in various places in the specification are not necessarily all referring to the same embodiment, nor are separate or alternative embodiments mutually exclusive of other embodiments. Further, the order of blocks in process flowcharts or diagrams or the use of sequence numbers representing one or more embodiments of the invention do not inherently indicate any particular order nor imply any limitations in the invention.

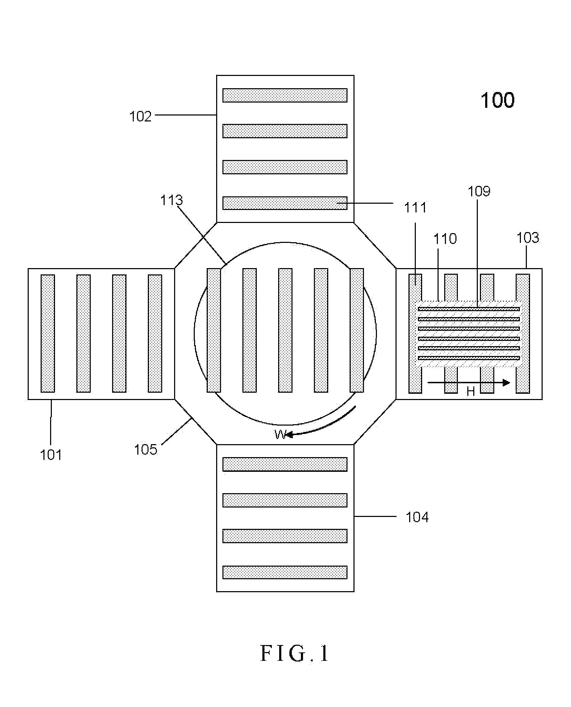

Embodiments of the present invention are discussed herein with reference to FIGS. 1-9D. However, those skilled in the art will readily appreciate that the detailed description given herein with respect to these figures is for explanatory purposes as the invention extends beyond these limited embodiments.

Referring now to the drawings, in which like numerals refer to like parts throughout the several views. FIG. 1 shows an exemplary configuration 100 according to one embodiment of the present invention. The configuration 100 includes a transfer chamber 105, one or more process chambers (only three representative chambers 102, 103 and 104 are shown) and one or more load lock chambers (only one representative chamber 101 is shown). As the name implies, a load lock chamber is used for receiving objects or workpieces and getting them ready for loading into one of the process chambers.

According to one embodiment, the transfer chamber 105 includes a rotary stage 113 that turns around to align with one of the process chambers to load or unload the workpieces. Depending on the implementation, the process chambers may be designed identically or each of the process chambers may be configured to treat the workpieces differently. For example, all available process chambers may be used together to treat workpieces simultaneously to increase the throughput. If a set of workpieces needs to be treated with two different types of chemical components, different chemical component may be loaded into each of the chambers. Thus a first process chamber is used to treat the workpieces with a first chemical component, a second process chamber is used to treat the workpieces with a second chemical component, where the transfer chamber 105 may be used to transfer the workpieces from the first process chamber to the second process chamber.

In one exemplary operation, an array of workpieces is removably positioned in a platform that may be moved in or out a chamber through a moving mechanism. The platform includes at least a fixture 110 that is loaded by the transfer chamber 105 into one of the process chambers. After the workpieces are processed, they are unloaded from the process chamber to the rotary stage on the transfer chamber. The rotary stage then rotates to a designated chamber (e.g., another one of the process chambers or the load lock chamber 101) to transfer the fixture therein. Depending on the implementation, the platform may be designed in different forms. Some exemplary platforms will be described below.

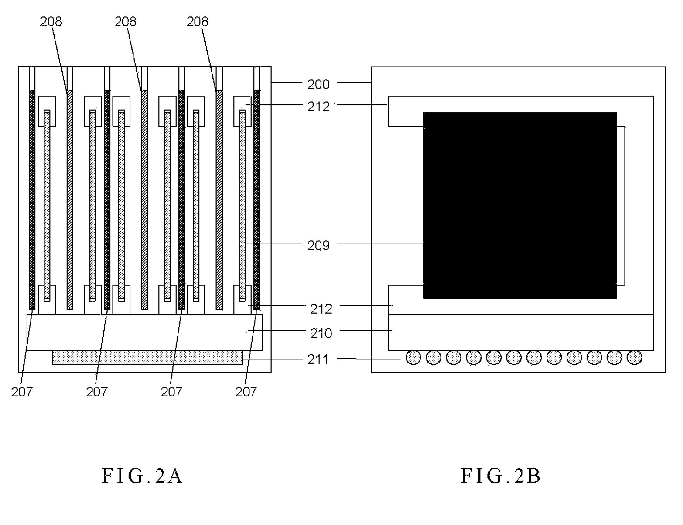

FIG. 2A and FIG. 2B show respectively a front view and a cross sectional view of a process chamber 200. According to one embodiment, the process chamber 200 is a housing with an opening on one end. The opening provides a mechanism to receive workpieces for treatment in the process chamber. There are a number of electrodes arranged in parallel in the process chamber 200. According to the embodiment shown in FIG. 2A, there are three planar RF electrodes 208 and four planar ground electrodes 207. To effectively use the planar electrodes, the three RF electrodes 208 and four ground electrodes 207 are arranged symmetrically. The electrode pairs are arranged back-to-back to each other. In other words, the RF electrode in the center shares in two electrode pairs. As a result, the three RF electrodes 208 interleave the four ground electrodes 207.

In one embodiment, these planar electrodes 207 and 208 are placed vertically but parallel to each other with a small space therebetween. Given the configuration shown in FIG. 2A, there are six workpieces 209 that can be positioned between two electrodes, one RF electrode and one ground electrode. The front surface of a workpiece, being a treatment surface, faces the RF electrode. The back surface of the workpiece is considered as a handling surface and positioned closer to the ground electrode. Because the gap between the back surface and the ground electrode is usually very small, a mechanical maneuver would be difficult, or displacement of the electrodes may be required in order to make room for handling the workpiece, which is mechanically complex and makes a process chamber large in size.

According to another embodiment, there are a number of outlets positioned on at least one of the electrodes, for example, to feed a type of gas (e.g., reactant gas) or a chemical component into a process chamber. These outlets may be distributed or arranged on the surface of an RF electrode facing another electrode. Thus when a workpiece is inserted between an RF electrode and a ground electrode, the gas or chemical component may effectively treat the workpiece.

As shown in FIG. 2A or 2B, a platform includes a fixture 210 and an array of rollers 211, where the fixture 210 is landed on the rollers 211. To allow for parallel handling of the workpieces, one fixture can hold a number of workpieces. The fixture 210, as shown, includes six sets of holders 212, each set designed to hold one of the workpieces to be treated in the process chamber. A pair of holders 212 is explicitly shown to hold a workpiece 209 in FIG. 2B. The fixture 200 allows all workpieces being held to be moved in or out, or between the process chambers simultaneously.

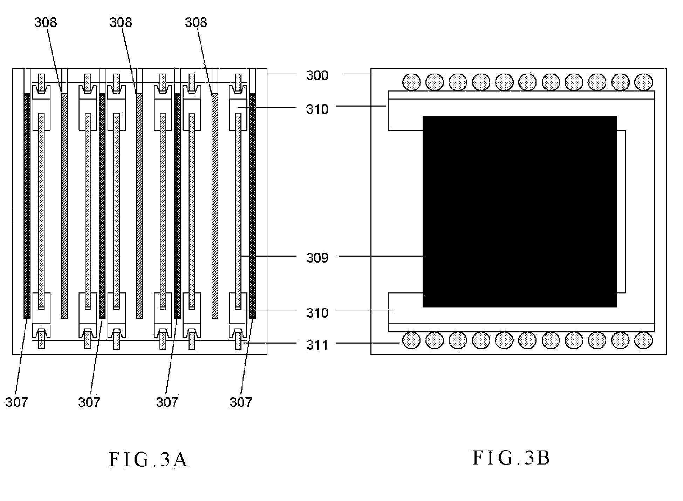

FIG. 3A and FIG. 3B show respectively a front view and a cross sectional view of a process chamber 300 that includes a plurality of fixtures. In other words, a platform now includes a plurality of fixtures, an exact number of which may be predetermined depending on the size of the chamber 300. Each of the fixtures is landed on an array of rollers 211, FIG. 3B shows that such a fixture 310 holding a workpiece 309, the front view of the fixture 310 may be seen as one of the six fixtures shown in FIG. 3A. It should be noted that each of the fixtures is landed on one set of roller 311 as shown in FIG. 3B. If necessary, each of the workpieces can be moved independently or together.

To transfer the fixtures 210 or fixtures 310 from a process chamber 200 or 300 or a load lock chamber 101 into a transfer chamber 105, the rotary stage 113 of the transfer chamber 105 is rotated until the rollers in the transfer chamber are aligned with the rollers in the process chamber 200 or the load lock chamber 101. Once aligned, the rollers are activated such that the fixture(s) is transferred in or out of the process chamber 200 or the load lock chamber 101. The rollers are stopped when the fixture reached a designated position inside the transfer chamber.

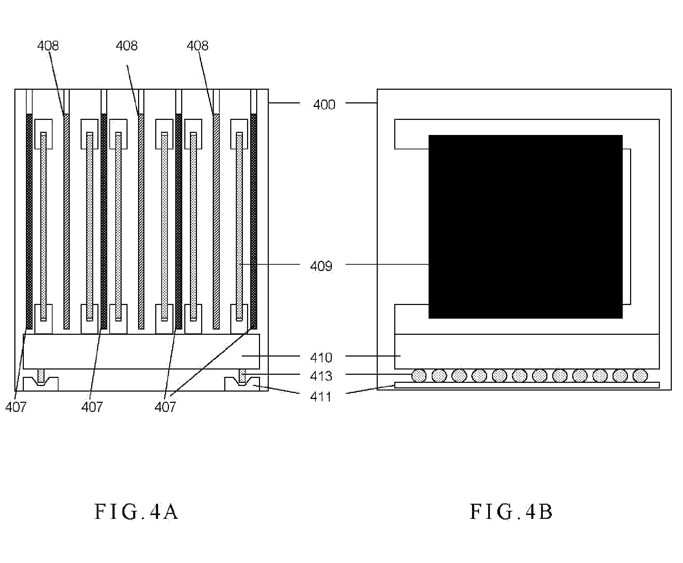

FIG. 2A, 2B, 3A or 3B shows that the fixture(s) is moved or transferred by an array of rollers or sets of rollers. Depending on implementation, there are other moving mechanisms that may be used to move a platform or fixture(s). One exemplary moving mechanism is to use rails to transfer the fixture(s). FIG. 4A and FIG. 4B show respectively a front view and a cross sectional view of a process chamber 400 that includes a fixture 410 with wheels 413 running on a set of rails 411. Similar rails may be also provided in the load lock chamber or the transfer chamber so that the fixture 410 can be transferred from one chamber to another. According to another embodiment, another set of rails may be mounted on the ceiling of the process chamber 400 to firmly guide the motion of the fixture 410.

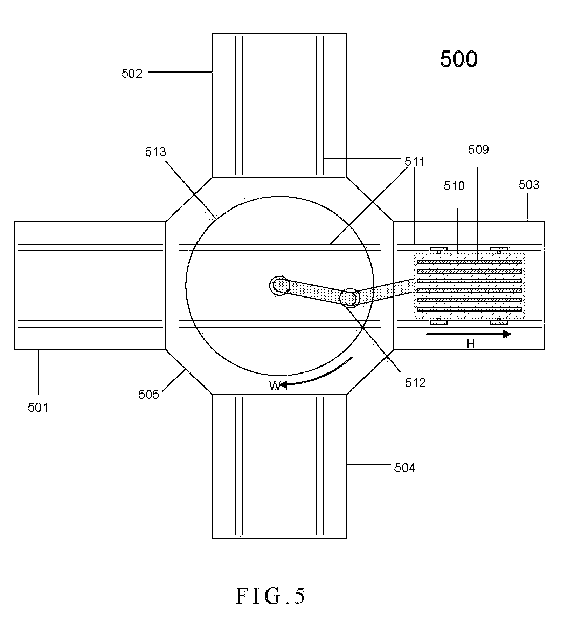

FIG. 5 shows an exemplary configuration 500 using a transfer device 512 to move a fixture from one chamber to another. According to one embodiment of the present invention, the configuration 500 includes a transfer chamber 505, one or more process chambers (only three representative chambers 502, 503 and 504 are shown) and one or more load lock chambers (only one representative chamber 501 is shown).

In one embodiment, to move the fixture from one chamber to another chamber, the transfer device is a mechanical arm extended towards the fixture in one chamber and then attached to the fixture. The mechanical arm is then retracted towards another chamber (e.g., the transfer chamber) while still attached to the fixture. As a result, the fixture is moved out of one chamber and moved into another chamber (e.g., the transfer chamber) along the rails in the horizontal direction, where it is assumed that the rails are aligned by the rotary stage 513. After the fixture is moved into the transfer chamber, the rotary stage is rotated until the rails are aligned with the destination chamber. The mechanical arm is then extended towards the destination chamber. As a result, the fixture is moved out of the transfer chamber and moved into the destination chamber. After the fixture is placed at the designated position, the mechanical arm is detached from the fixture and retracts back.

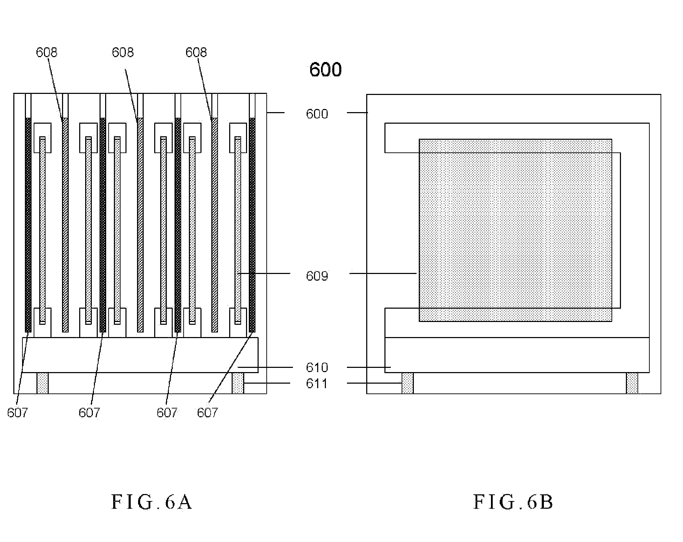

According to another embodiment, a mechanical manipulator is used to move the fixture. FIGS. 6A and 6B show respectively a front view and a cross sectional view of a process chamber 600 that includes a fixture 610. The fixture 610 is landed on a set of studs 611 that provides a space for the mechanical manipulator (e.g., a lifting mechanism) to extend towards the bottom of the fixture 610. The lifting mechanism raises the fixture 610 and retracted towards the center of the transfer chamber. As a result, the fixture is lifted and moved to the transfer chamber.

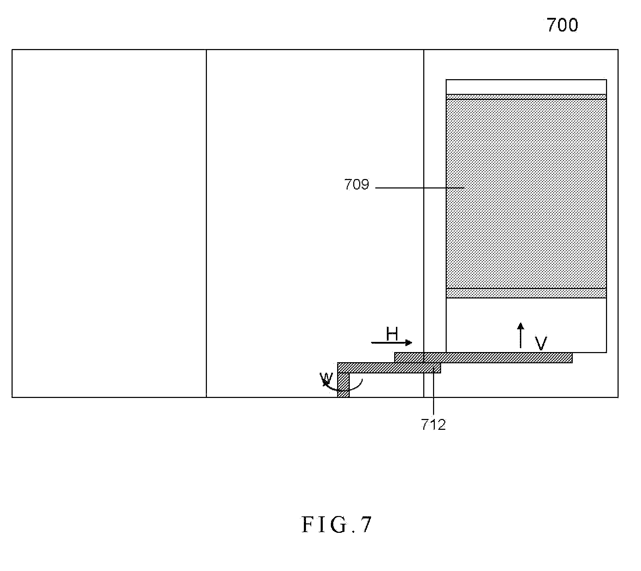

To move the fixture from the transfer chamber to a process chamber or the load lock chamber, the lifting mechanism holding the fixture is rotated until the fixture is aligned with the process chamber or the load lock chamber. Then, as shown in FIG. 7, the lifting mechanism 713 is extended towards the designated chamber. When the fixture reaches the designated position inside the designated chamber, the lifting mechanism is lowered and the fixture is placed in the designated chamber. The lifting mechanism is then retracted from the designated chamber into the transfer chamber.

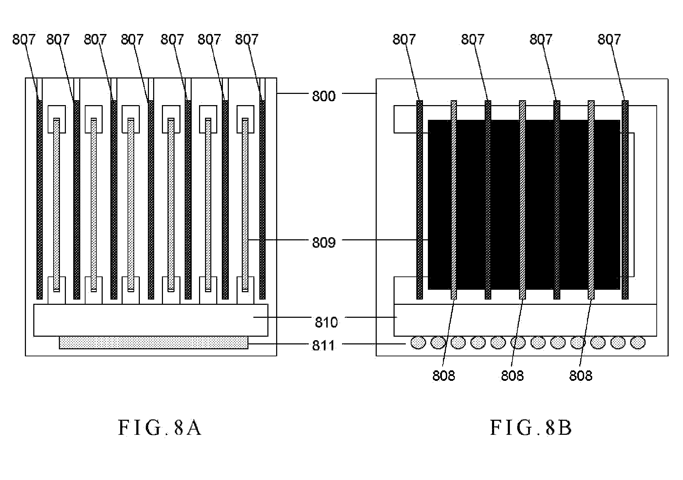

FIGS. 8A and 8B show together another embodiment in which RF electrodes 808 interleave the ground electrodes 807 along the planar surface of the workpiece 809. The workpiece is held in between a pair of electrode arrays using a fixture 810. The fixture 810 being landed on the rollers 811 allows the workpieces to be positioned in a narrow gap between the pair of electrode arrays.

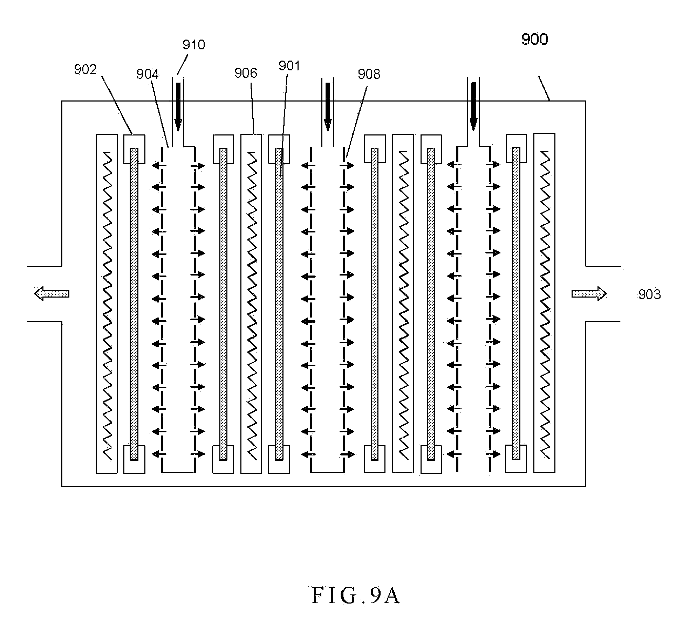

FIG. 9A shows an exemplary processing chamber 900 designed to process planar workpieces according to one embodiment of the present invention. The chamber 900 includes at least a fixture 902 to hold up a workpiece 901 vertically. One of the benefits for holding up a workpiece vertically is to minimize possible particles (e.g., dusts or deposition material residuals) falling onto the workpiece. Further, the chamber 900 includes a deposition assembly 904, a heater 906 and at least one outlet 903 to release chemical residuals.

As shown in FIG. 9A, the deposition assembly 904 includes an opening 910 and at least one injection panel 908 through which some chemicals (e.g. air, nitrogen or a kind of gas) may be supplied into the deposition assembly 904. The injection panel 908 includes an array of holes and positioned face to the workpiece. Through the holes on the injection panel 908, the chemicals may be released into the chamber or injected onto the workpiece. Any leftover or residuals of the chemicals are released through the outlet 903. In addition, the outlet 903 may be used to balance the pressure in the processing chamber 900. In one embodiment, the outlet 903 is connected to a pump (not shown) that facilitates the release of the pressure or possible leftover or residuals of the chemicals being used for treating the workpiece.

According to one embodiment, the heater 906 is coupled to an electrical ground and the injection panel 908 is coupled to a RF source. With the potential difference or an electromagnetic field created between the heater 906 and the injection panel 908, the chemicals are excited and caused to be deposited into the workpiece positioned between the heater 906 and the injection panel 908.

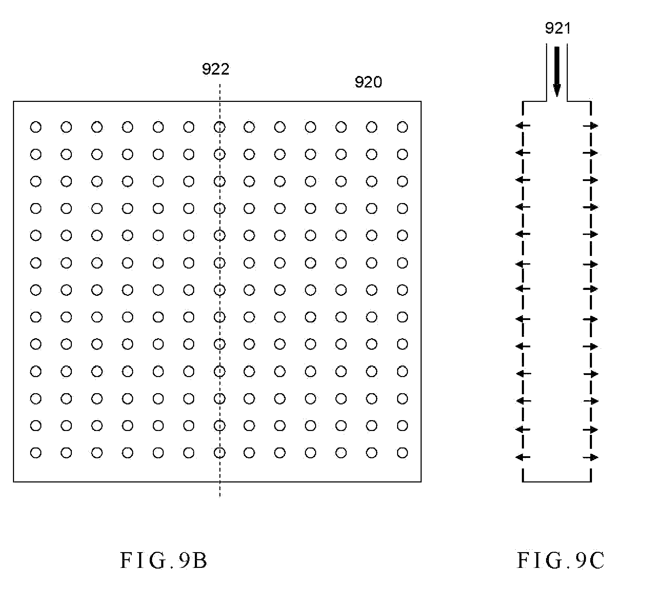

To ensure that the chemicals are deposited evenly onto the workpiece, in one embodiment, the injection panel 908 is designed to include an array of holes, as shown in FIG. 9B, to release the chemicals from the deposition assembly 904 into the chamber. FIG. 9C shows a cross-section side view of the deposition assembly 904.

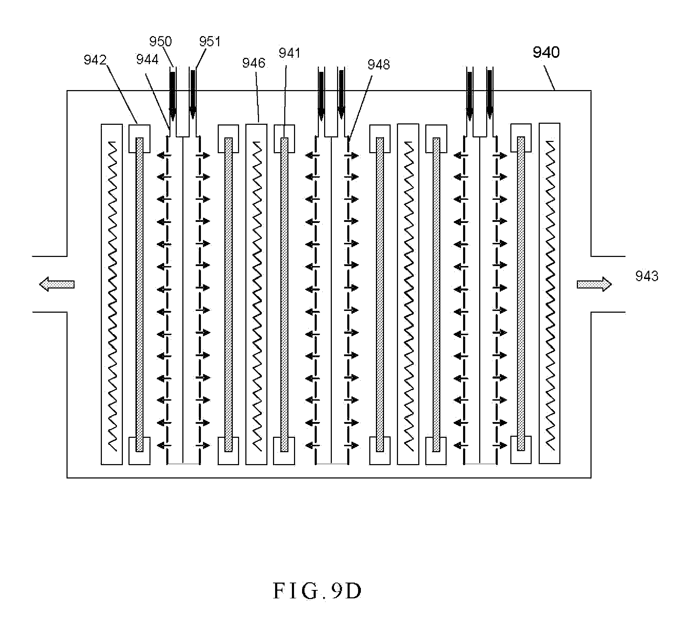

The embodiment shown in FIG. 9A shows that the deposition assembly 904 includes two injection panels similar to the injection panel 920. The deposition assembly 904 is positioned between two workpieces. As a result, chemicals can be deposited onto the two workpieces through the two injection panels simultaneously. FIG. 9D shows another embodiment in which an integrated deposition assembly 944 is used. As shown in FIG. 9D, the integrated deposition assembly 944 includes two separated chambers or channels, each receiving the chemical component(s) from its own supply 950 or 951 and including its own injection panel (e.g., the one shown in FIG. 9B).

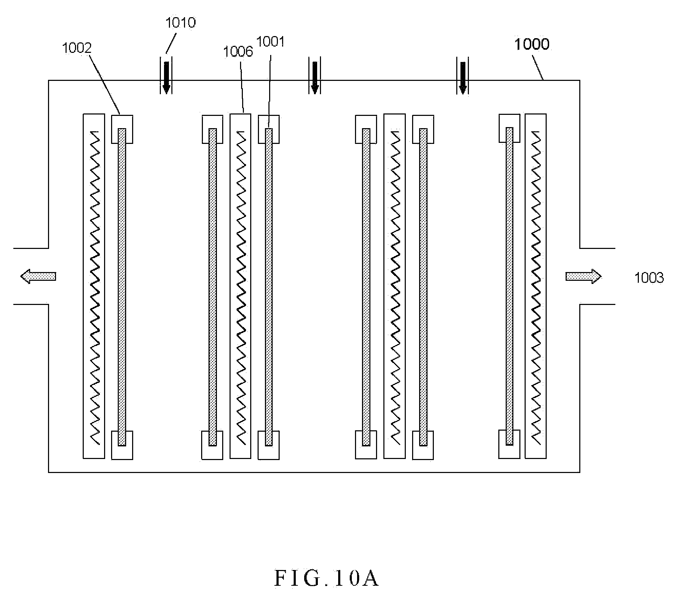

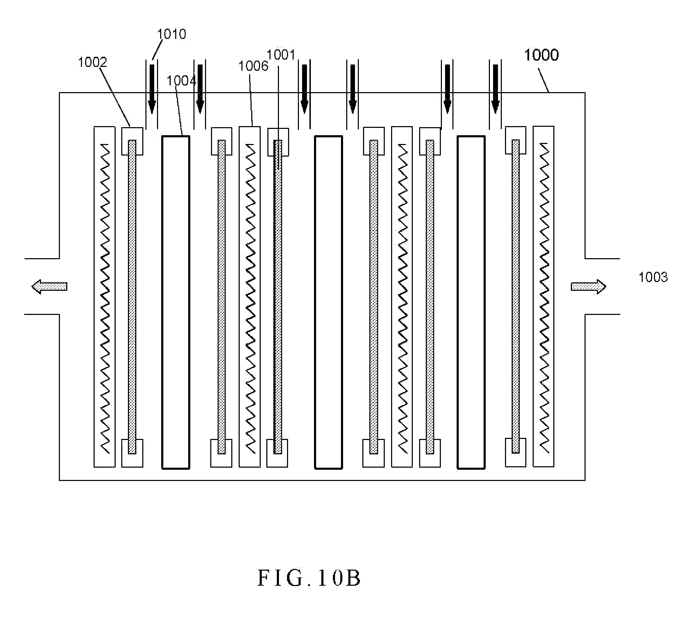

The embodiment in FIG. 10A shows a configuration without the deposition assembly. Heaters 1006 are positioned next to the workpieces 1001. Chemicals can be deposited into the chamber 1000 through the openings 1010. Similarly any leftover or residuals of the chemicals are released through the outlet 1003. In addition, the outlet 1003 may be used to balance the pressure in the chamber 1000. In one embodiment, the outlet 903 is connected to a pump (not shown) that facilitates the release of the pressure or possible leftover or residuals of the chemicals being used for treating the workpieces in chamber 1000. The embodiment in FIG. 10B shows a deposition assembly 1004 being positioned between heaters 1006. The deposition assembly 1004 may be coupled to a RF source, and the heater 1006 may be coupled to an electrical ground to excite the chemical in the chamber 1000.

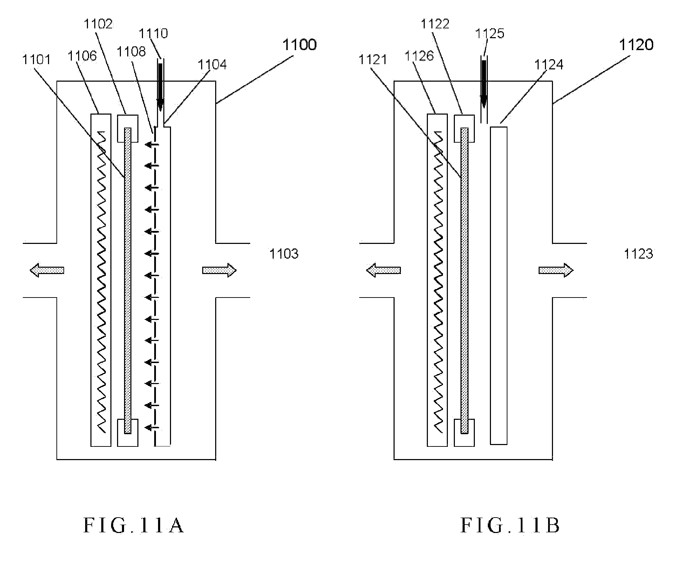

The embodiment shown in FIG. 11A shows a workpiece 1101 is held up by a fixture 1102. Chemicals are injected through the openings on the injection panel 1108. In another embodiment shown in FIG. 11B, chemicals are injected through the opening 1125 on the chamber 1120. The deposition assembly 1104 or 1124 may be coupled to a RF source and the heater 1106 or 1126 may be coupled to electrical ground to excite the chemical in the chamber.

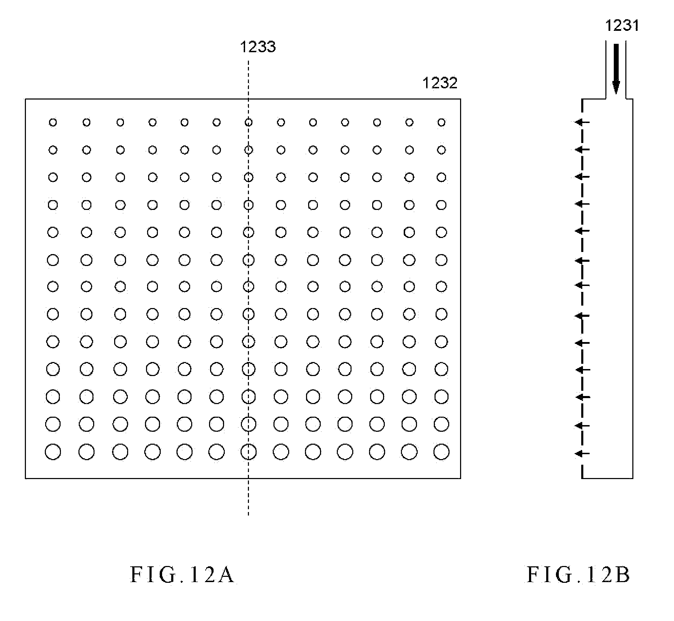

FIG. 12A shows that an injection panel 1232 is designed to include an array of holes that are progressively enlarged from top to bottom. In other words, the holes in the bottom portion of the injection panel 1232 are larger than that in the top portion of the injection panel 1232. By providing larger holes along the injection panel 1232, a chemical supply from the opening 908 can be more evenly deposited onto the workpiece through the holes. For completeness, FIG. 12B shows a cross-section side view of a deposition assembly with the injection panel 1232.

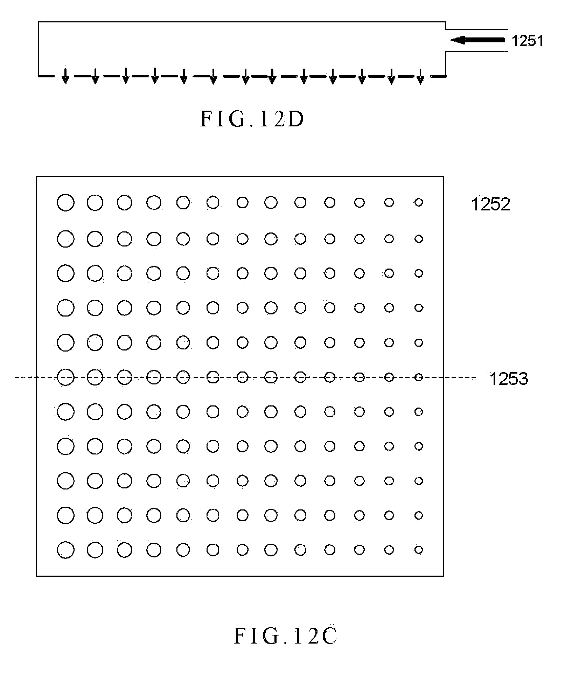

FIG. 12C shows that an injection panel 1252 is designed to include an array of holes that are progressively enlarged from one side to another. In other words, the holes on one side of the injection panel 1252 are larger than that on the other side of the injection panel 1252. Likewise, FIG. 12D shows a cross-section side view of a deposition assembly with the injection panel 1252, the injection opening 1251 is positioned near the side with smaller holes.

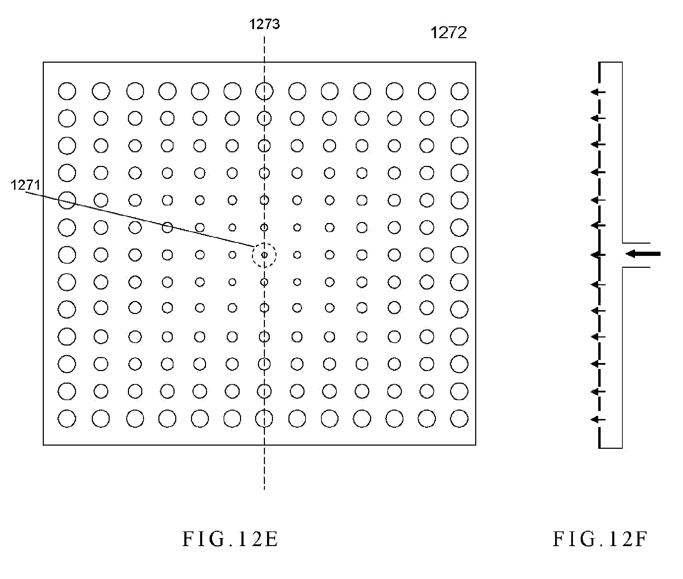

FIG. 12E shows that an injection panel 1272 is designed to include an array of holes that are progressively enlarged outwards. FIG. 12F shows a cross-section side view of a deposition assembly with the injection panel 1272, the injection opening 1271 is positioned near the center of the side injection panel 1272 with smaller holes.

The present invention discloses a system for processing workpieces or depositing one or more types of chemical thereon. The invention may be used in many applications, such as treating workpieces with chemical components. For example, one embodiment of the present invention can be advantageously used in plasma enhanced chemical vapor deposition (PECVD) that is a process mainly to deposit thin films from a gas state (vapor) to a solid state on some substrate. A further example is the use in chemical vapor deposition (CVD) in which electric power is not applied to the deposition assembly or deposition assembly is omitted.

The present invention has been described in sufficient details with a certain degree of particularity. It is understood to those skilled in the art that the present disclosure of embodiments has been made by way of examples only and that numerous changes in the arrangement and combination of parts may be resorted without departing from the spirit and scope of the invention as claimed. Accordingly, the scope of the present invention is defined by the appended claims rather than the foregoing description of embodiments.

## Claims

1. A system for processing workpieces, the system comprising: a chamber including: an opening to receive at least one type of chemical; a platform, including at least one fixture to hold at least one workpiece vertically; a heater positioned next to a first surface of the workpiece; and an outlet to release the residual or leftover to balance the pressure in the chamber.

2. The system as recited in claim 1, wherein a deposition assembly is positioned facing the heater.

3. The system as recited in claim 2, wherein the deposition assembly is positioned between two heaters.

4. The system as recited in claim 2, wherein the heater is coupled to an electrical ground, and the deposition assembly is coupled to a RF source to create an electromagnetic field that excites the chemical for deposition onto the workpiece.

5. The system as recited in claim 3, wherein the heaters are coupled to an electrical ground, and the deposition assembly is coupled to a RF source to create an electromagnetic field that excite the chemical for deposition onto the workpiece.

6. The system as recited in claim 2, wherein the deposition assembly includes an injection panel with holes on the surface facing the heater, the chemical is injected onto the workpiece through the injection panel.

7. The system as recited in claim 3, wherein the deposition assembly includes an injection panel with holes on the surface facing the heaters, the chemical is injected onto the workpiece through the injection panel.

8. The system as recited in claim 4, wherein the deposition assembly includes an injection panel with holes on the surface facing the heater, the chemical is injected onto the workpiece through the injection panel.

9. The system as recited in claim 5, wherein the deposition assembly includes an injection panel with holes on the surface facing the heaters, the chemical is injected onto the workpiece through the injection panel.

10. The system as recited in claim 6, wherein the holes are progressively enlarged in size from top to bottom.

11. The system as recited in claim 7, wherein the holes are progressively enlarged in size from top to bottom.

12. The system as recited in claim 8, wherein the holes are progressively enlarged in size from top to bottom.

13. The system as recited in claim 9, wherein the holes are progressively enlarged in size from top to bottom.

14. The system as recited in claim 7, wherein each of the deposition assemblies includes two chemical chambers, each of the chemical chambers receiving at least a chemical component from its own supply and one of the two injection panels with holes.

15. The system as recited in claim 9, wherein each of the deposition assemblies includes two chemical chambers, each of the chemical chambers receiving at least a chemical component from its own supply and one of the two injection panels with holes.

16. The system as recited in claim 11, wherein each of the deposition assemblies includes two chemical chambers, each of the chemical chambers receiving at least a chemical component from its own supply and one of the two injection panels with holes.

17. The system as recited in claim 13, wherein each of the deposition assemblies includes two chemical chambers, each of the chemical chambers receiving at least a chemical component from its own supply and one of the two injection panels with holes.

18. The system as recited in claim 9, further comprising: a transfer chamber for transferring the workpieces in or out of the chamber; and another chamber to receive the workpieces from the transfer chamber; and the platform is transferred using rollers.

19. The system as recited in claim 9, further comprising: a transfer chamber for transferring the workpieces in or out of the chamber; and another chamber to receive the workpieces from the transfer chamber; and the platform is transferred using rails.

20. The system as recited in claim 9, further comprising: a transfer chamber for transferring the workpieces in or out of the chamber; and another chamber to receive the workpieces from the transfer stage; and a mechanical manipulator provided to move the platform in and out of the chamber, where functions of the manipulator include: raising the platform; moving the platform in the horizontal direction; and rotating the platform about a vertical axis.
